# EUROPÄISCHE PATENTANMELDUNG

(11) **EP 1 237 206 A2**
(43) Veröffentlichungstag der Anmeldung: **04.09.2002**
(21) Anmeldenummer: 02000977.5
(22) Anmeldetag: 16.01.2002
(51) Int. Cl.: H01L 41/107

(54) **Piezotransformator mit grossem Übersetzungsverhältnis**

(30) Priorität: 01.03.2001 DE 10109994
(71) Anmelder: Patent-Treuhand-Gesellschaft für elektrische Glühlampen mbH, 81543 München (DE)
(72) Erfinder: Gueldner, Henry, Prof., 01809 Heidenau (DE); Hanisch, Thomas, 04758 Oschatz (DE); Kartashev, Igor, 01062 Dresden (DE)

(57) **Zusammenfassung**

Piezoelektrischer Transformator mit einem Ein- und einem Ausgangsbereich. Ein- und/oder Ausgangsbereich sind in Sektionen (13-16) unterteilt, die inverse Polarisierung aufweisen. Je nach Anzahl der Sektionen erzielt man eine Vervielfachung des Übersetzungsverhältnisses, ohne die Feldstärke im piezoelektrischen Materials zu erhöhen.

## Beschreibung

### Technisches Gebiet

Die Erfindung betrifft piezoelektrische Transformatoren, im folgenden kurz Piezotransformatoren genannt. Insbesondere löst die Erfindung Probleme, die bei der Bereitstellung von Piezotransformatoren mit hohem Übersetzungsverhältnis auftreten.

### Stand der Technik

Aus der Schrift US 2,830,274 (Rosen) ist der Aufbau eines Piezotransformators bekannt, der ein großes Übersetzungsverhältnis liefern kann. Der Piezotransformator besteht aus einem piezoelektrischen Material, auf das Elektroden aufgebracht sind. Die Elektroden können auch in das piezoelektrische Material eingearbeitet sein. Wichtig ist, dass das sich zwischen den Elektroden ausbildende elektrische Feld eine Komponente in der Polarisierungsrichtung des piezoelektrischen Material besitzt. Der Piezotransformator besitzt ein Paar Eingangs-Anschlüsse und ein Paar Ausgangs-Anschlüsse. Die Eingangs-Anschlüsse sind mit zwei oder mehreren Elektroden verbunden. Durch Anlegen einer Eingangs-Spannung an die Eingangs-Anschlüsse wird das piezoelektrische Material in mechanische Schwingungen versetzt. Die Ausgangs-Anschlüsse sind auch mit zwei oder mehreren Elektroden verbunden. Aufgrund der mechanischen Schwingungen kann an den Ausgangsanschlüssen eine Ausgangsspannung abgegriffen werden. Eine oder mehrere Elektroden können sowohl mit einem Eingangs-Anschluss als auch mit einem Ausgangs-Anschluss verbunden sein.

Unter dem Begriff Übersetzungsverhältnis wird in diesem Zusammenhang das Verhältnis der Ausgangsspannung zur Eingangsspannung verstanden. In der o. g. Schrift ist ein Piezotransformator beschrieben, der in einen Eingangsbereich und einen Ausgangsbereich unterteilt ist. Die Anregung der mechanischen Schwingung geschieht vorwiegend im Eingangsbereich, während die Erzeugung der Ausgangsspannung vorwiegend im Ausgangsbereich geschieht. Unterschiedlich in den beiden Bereichen ist die Polarisierungsrichtung des piezoelektrischen Materials. Innerhalb eines Bereichs gibt es jedoch nur eine Polarisierungsrichtung. Die Spannung zwischen zwei Elektroden ist naturgemäß das Integral der elektrischen Feldstärke entlang des Weges zwischen den Elektroden. Für eine effektive Umsetzung von elektrischer Spannung in mechanischen Druck sind die Elektroden so angeordnet, dass der Integrationsweg zwischen den Elektroden möglichst in Richtung der Polarisierung verläuft. Das Übersetzungsverhältnis eines derartigen Piezotransformators ist demnach abhängig vom Verhältnis der Integrationswege zwischen des Aus- und den Eingangselektroden. Damit ist das Verhältnis der wesentlichen geometrischen Abmessungen des Piezotransformators bei gegebenem Übersetzungsverhältnis festgelegt. Für die absoluten geometrischen Abmessungen sind folgende Zusammenhänge von Bedeutung:

Der Wirkungsgrad eines Piezotransformators ist nur dann optimal wenn er bei einer Frequenz betrieben wird, die eine resonante Schwingung bewirkt. Demgemäss erfordern kleinere geometrische Abmessungen eine höhere Betriebsfrequenz. Für viele Anwendungen sollte die Betriebsfrequenz bestimmte Grenzen nicht überschreiten, was einer Miniaturisierung des Piezotransformators und damit einer Kostenreduzierung im Wege steht. Z. B. bei der Anwendung in Betriebsgeräten für Gasentladungslampen sollte wegen der gegebenenfalls langen Zuleitung zur Lampe eine Betriebsfrequenz von 100kHz nicht überschritten werden.

Das piezoelektrische Material ist nur bis zu einer bestimmten Grenze für die elektrische Feldstärke geeignet. Sollen hohe Ausgangsspannungen, wie z. B. zur Zündung einer Gasentladungslampe erzielt werden, so ergibt sich daraus ein Mindestabstand für die mit den Ausgangs-Anschlüssen verbundenen Elektroden.

### Darstellung der Erfindung

Es ist Aufgabe der vorliegenden Erfindung, einen Piezotransformator gemäß dem Oberbegriff des Anspruchs 1 bereitzustellen, der gegenüber dem Stand der Technik eine Modifikation des Übersetzungsverhältnisses erlaubt, ohne die o. g. Beschränkungen zu verletzen.

Diese Aufgabe wird erfindungsgemäß dadurch gelöst, dass der Eingangsbereich und/oder der Ausgangsbereich in Sektionen aufgeteilt wird, wobei aneinander angrenzende Sektionen invers zueinander polarisiert sind. Invers bedeutet in diesem Zusammenhang, dass die Polarisierung verschiedener Sektionen entlang von parallelen Linien verläuft, die Richtung der Polarisierung jedoch umgekehrt ist. Die Elektroden sind mit den Anschlüssen so verschaltet, dass die Sektionen im Eingangsbereich als parallel geschaltet und im Ausgangsbereich als seriell geschaltet aufgefasst werden können. Das Übersetzungsverhältnis kann dadurch vervielfacht werden, ohne die Belastung des piezoelektrischen Materials bezüglich der elektrischen Feldstärke zu erhöhen. Der erfinderische Gedanken muss nicht zwangsläufig im Eingangsbereich und Ausgangsbereich gleichzeitig ausgeführt sein. Es kann auch nur der Eingangsbereich oder nur der Ausgangsbereich erfindungsgemäß ausgestaltet sein. Die Auswirkung auf das Übersetzungsverhältnis ist in diesem Fall reduziert.

An den Eingangsbereich schließt sich der Ausgangsbereich an. Dadurch wird eine Richtung festgelegt. Die Richtung in der vom Eingangsbereich gesehen der Ausgangsbereich liegt wird im folgenden als longitudinal bezeichnet.

Erfindungsgemäß wird für den Eingangsbereich in longitudinaler Richtung eine Abmessung gewählt, die einer halben Wellenlänge entspricht. Angaben zur Wellenlänge beziehen sich hier und im folgenden auf die im Betrieb sich einstellende mechanische Schwingung. Im einfachsten Fall ist der Eingangsbereich nur in 2 Sektionen unterteilt, die bevorzugt gleiche Abmessungen in longitudinaler Richtung aufweisen. Die Polarisierung in den beiden Sektionen ist entweder auf die Verbindungsstelle der beiden Sektionen hin oder von ihr weg gerichtet. Ein erster Eingangs-Anschluss ist mit einer Elektrode verbunden, die im Bereich der Verbindungsstelle der beiden Sektionen wirkt. Zwei weitere Elektroden sind so angebracht dass sie in longitudinaler Richtung jeweils an dem Ende einer der beiden Sektionen wirken, das der Verbindungsstelle der beiden Sektionen abgewandt ist. Diese beiden weiteren Elektroden sind miteinander verbunden und mit einem zweiten Eingangs-Anschluss verbunden.

Wie oben erwähnt, bildet sich erfindungsgemäß über dem Eingangsbereich in longitudinaler Richtung eine Halbwelle der mechanischen Schwingung aus. Bedingt durch die oben beschriebene erfindungsgemäße Anordnung muss an die Eingangsklemmen nur eine elektrische Spannung angelegt werden, wie sie für den mechanischen Druck in einer Sektion nötig ist. Die zweite Sektion kann wegen ihrer erfindungsgemäßen inversen Polarisation durch die selbe Eingangsspannung angesteuert werden, was einer Parallelschaltung der beiden Sektionen entspricht. Gegenüber einem, dem Stand der Technik entsprechenden, aus nur einer Sektion bestehenden Eingangsbereich wird das Übersetzungsverhältnis durch diesen einfachen Fall der Realisierung des erfinderischen Gedankens verdoppelt. Aufwendigere Ausgestaltungen finden sich in den Figuren.

Erfindungsgemäß wird für den Ausgangsbereich in longitudinaler Richtung eine Abmessung gewählt, die N/2 Wellenlängen entspricht, wobei N eine natürliche Zahl größer 1 ist. Im einfachsten Fall ist der Ausgangsbereich nur in 2 Sektionen unterteilt, die bevorzugt gleiche Abmessungen in longitudinaler Richtung aufwiesen. Die Polarisierung in den beiden Sektionen ist entweder auf die Verbindungsstelle der beiden Sektionen hin oder von ihr weg gerichtet. Zwei Ausgangs-Anschlüsse sind mit Elektroden verbunden, die an den Enden des Ausgangsbereichs bezüglich longitudinaler Richtung wirken. Erfindungsgemäß bildet sich für N=2 über dem Ausgangsbereich in longitudinaler Richtung eine ganze Welle der mechanischen Schwingung aus. Weil die beiden Halbwellen dieser ganzen Welle sich in Sektionen ausbilden, die erfindungsgemäß inverse Polarisierung aufweisen, wird die elektrische Spannung, die sich über der jeweiligen Sektion ergibt bezüglich der Ausgangsklemmen addiert, was einer Serienschaltung der beiden Sektionen des Ausgangsbereichs entspricht. Damit erhält man gegenüber einem, dem Stand der Technik entsprechenden, aus nur einer Sektion bestehenden Ausgangsbereich die doppelte Ausgangsspannung und damit das doppelte Übersetzungsverhältnis, ohne die elektrische Feldstärke im Ausgangsbereich zu Verdoppeln.

Im oben beschriebenen einfachen Fall ist der Ausgangsbereich in nur zwei erfindungsgemäß seriell geschaltete Sektionen unterteilt. Es ist jedoch möglich eine Unterteilung in beliebig viele Sektionen vorzunehmen. In jeder Sektion bildet sich erfindungsgemäß eine Halbwelle der mechanischen Schwingung aus, wobei aneinander angrenzende Sektionen invers zueinander polarisiert sind. An den in longitudinaler Richtung liegenden Enden des Ausgangsbereichs wirken Elektroden, die mit den Ausgangsklemmen verbunden sind. Die Anzahl der Sektionen, in die der Ausgangsbereich unterteilt ist bestimmt den Faktor der Spannungvervielfachung an den Ausgangsklemmen bezüglich einem Ausgangsbereich mit nur einer Sektion.

Da sich in einer Sektion des Ausgangsbereichs in longitudinaler Richtung eine Halbwelle der mechanischen Schwingung ausbildet, während sich im gesamten Eingangsbereich in longitudinaler Richtung eine Halbwelle der mechanischen Schwingung ausbildet, erhält man ein ganzzahliges Verhältnis für die Abmessungen der Sektionen des Ausgangsbereichs bezogen auf die Abmessungen der Sektionen des Eingangsbereichs jeweils in longitudinaler Richtung.

In der bisherigen Beschreibung wurde davon ausgegangen, dass für die Ausgangsspannung des Piezotransformators eine höhere Spannung gewünscht wird, als sie an den Eingangsklemmen eingespeist wird. Es sind jedoch auch Anwendungen für einen Piezotransformator denkbar, bei denen eine kleinere Ausgangsspannung als die Eingangsspannung gewünscht wird. In diesen Fällen sind die Eingangsklemmen gegen die Ausgangsklemmen zu vertauschen. Der Piezotransformator wird dann in umgekehrter Richtung betrieben.

Naheliegend für die geometrische Topologie eines erfindungsgemäßen Piezotransformators ist der Quader. Jedoch lässt sich der erfinderische Gedanke auch in anderen geometrischen Topologien realisieren. Es ist möglich den beschriebenen erfindungsgemäßen Aufbau des Piezotransformators in Form einer Scheibe oder eines Ringes zu realisieren, wobei die longitudinale Richtung radial verläuft. Es ist auch möglich den beschriebenen erfindungsgemäßen Aufbau des Piezotransformators in Form eines Zylinders oder eines Rohres zu realisieren, wobei die longitudinale Richtung in Richtung der Mittelachse verläuft.

Wie oben erläutert kann der erfinderische Gedanke sowohl auf den Eingangsbereich als auch auf den Ausgangsbereich angewendet werden. Wird der erfinderische Gedanke nur auf einen Bereich angewendet, so ist es möglich, auf den anderen Bereich andere Methoden anzuwenden, die den in den Ausführungen zum Stand der Technik angesprochenen Problemen begegnen.

Der erfinderische Gedanke, nämlich die Aufteilung eines Bereichs in Sektionen und deren Parallel- oder Serienschaltung zur Modifikation des Übersetzungsverhältnisses, kann im Vergleich zu den obigen Ausführungen auch in abgewandelter Form realisiert werden. Beispielsweise kann der Eingangsbereich eines Piezotransformators in zwei Sektionen unterteilt werden, die bevorzugt gleiche Abmessungen in longitudinaler Richtung aufweisen. Die Richtung der Polarisierung ist nicht longitudinal sondern senkrecht dazu und zwar in einer Richtung, in der die geometrische Abmessung möglichst gering ist. Beispielsweise bei einem plattenförmigen Quader würde der Eingangsbereich entsprechend der abgewandelten Realisierung des erfinderischen Gedankens in Richtung der Dicke des Quaders polarisiert sein. Diese Richtung sei im folgenden mit transversal bezeichnet. Die Polarisierung der beiden Sektionen muss im Gegensatz zu den bisherigen Ausführungen nicht invers zu einander sein sondern kann invers oder gleich sein. Jede Sektion des Eingangsbereichs besitzt entsprechend der abgewandelten Realisierung des erfinderischen Gedanken ein Paar von Elektroden, die geeignet sind, um in transversaler Richtung ein elektrisches Feld aufzubauen. Bezüglich der Eingangs-Anschlüsse können die beiden Sektionen parallel oder seriell geschaltet sein. Erfindungsgemäß ist die Verschaltung der Elektroden mit den Eingangsanschlüssen und die Polarisierung der Sektionen so zu wählen, dass eine gegebene Eingangsspannung in einer Sektion ein elektrisches Feld erzeugt, das in Richtung der Polarisierung zeigt und in der anderen Sektion entgegen der Richtung der Polarisierung zeigt. Damit ist es möglich mit einer reduzierten Eingangsspannung im Eingangsbereich eine gewünschte mechanische Schwingung zu erzeugen, wodurch das Übersetzungsverhältnis erhöht wird.

Wird der Piezotransformator wie oben erläutert, in umgekehrter Richtung betrieben, so gelten obige Ausführungen zur abgewandelten Realisierung des erfinderischen Gedankens für den Ausgangsbereich. Es ist auch möglich die abgewandelte Realisierung des erfinderischen Gedankens auf mehr als zwei Sektionen anzuwenden.

### Beschreibung der Zeichnungen

Im folgenden soll die Erfindung anhand mehrerer Figuren näher erläutert werden. Es zeigen:
- Figur 1: Seitenansicht eines erfindungsgemäßen quaderförmigen Piezotransformators
- Figur 2: Weitere Ausführungsform für den Eingangsbereich eines erfindungsgemäßen quaderförmigen Piezotransformator
- Figur 3: Erfindungsgemäßer Piezotransformator in Form eines Ringes
- Figur 4: Erfindungsgemäßer Piezotransformator in Form eines Rohres
- Figur 5: Weitere Ausführungsform für den Eingangsbereich eines erfindungsgemäßen quaderförmigen Piezotransformator

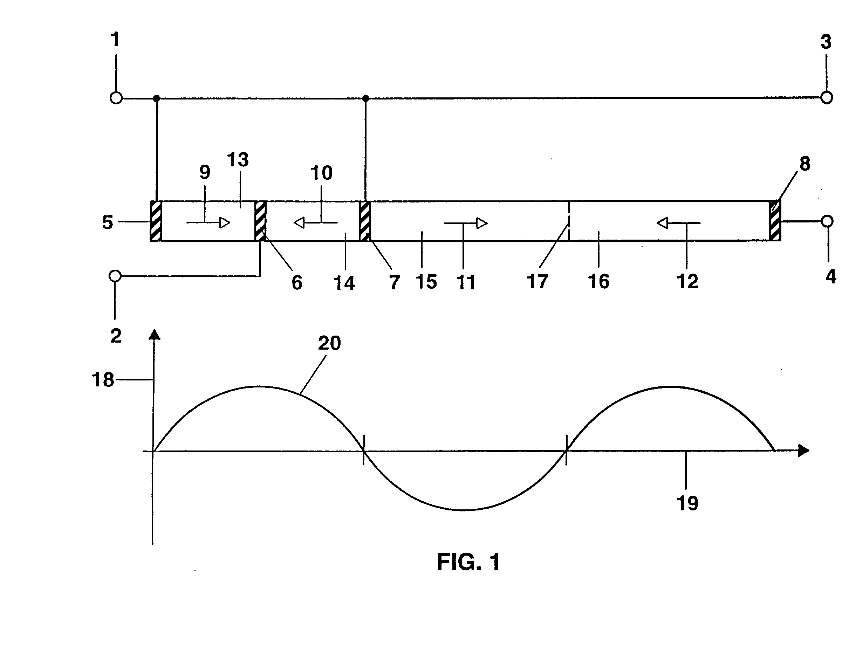

Im oberen Teil der Figur 1 ist die Seitenansicht eines quaderförmigen erfindungsgemäßen Piezotransformators dargestellt. Der Piezotransformator ist in einen Eingangsbereich und einen Ausgangsbereich gegliedert. Der Eingangsbereich ist in zwei Sektionen 13 und 14 unterteilt. Ihre Polarisierung verläuft in longitudinaler Richtung, wobei die Sektionen 13 und 14 invers zueinander polarisiert sind. Pfeile 9 und 10 deuten die Polarisierung an. Zwischen den Sektionen 13 und 14 und an den Enden des Eingangsbereichs in longitudinaler Richtung sind Elektroden 5, 6 und 7 aufgebracht. Die Elektroden können sowohl an der Oberfläche als auch innerhalb des Piezotransformators liegen. Die Wirkung innen liegender Elektroden ist in der Regel besser, jedoch ist dabei der Herstellungsaufwand höher. Die zwischen den Sektionen 13 und 14 gelegene Elektrode 6 ist mit einem ersten Eingangs-Anschluss 2 verbunden. Die an den Enden liegenden Elektroden 5 und 7 sind miteinander und mit einem zweiten Eingangs-Anschluss 1 verbunden.

An die Sektion 14 schließt sich der Ausgangsbereich an. Er ist aufgeteilt in zwei Sektionen 15 und 16. Zur Verdeutlichung der Aufteilung ist eine Trennlinie 17 eingezeichnet. Die Polarisierung des Ausgangsbereichs verläuft in longitudinaler Richtung, wobei die Sektionen 15 und 16 invers zueinander polarisiert sind. Pfeile 11 und 12 deuten die Polarisierung an. Am Ende der Sektion 16 und damit am Ende des Piezotransformators ist eine Elektrode 8 aufgebracht. Für diese gelten die gleichen allgemeinen Aussagen, wie sie oben für die Elektroden 5, 6 und 7 getroffen wurden. Die Elektrode 8 ist mit einem Ausgangs-Anschluss 4 verbunden. Die zwischen dem Ein- und dem Ausgangsbereich liegende Elektrode 7 wird für den Ein- und den Ausgangsbereich verwendet. Zusätzlich zu den oben erwähnten Verbindungen ist sie mit einem zweiten Ausgangsanschluss 3 verbunden. Es ist auch möglich die Elektrode 7 doppelt auszuführen und je eine Elektrode dem Ein- und dem Ausgang zuzuordnen. Damit ist eine Potenzialtrennung zwischen Ein- und Ausgang des Piezotransformators zu erreichen.

Im unteren Teil von Figur 1 ist ein Diagramm mit den Achsen 18 und 19 aufgezeichnet. Die Achse 19 stellt eine Ortsachse in longitudinaler Richtung des Piezotransformators dar, während die Achse 18 ein Maß für den mechanischen Druck im piezoelektrischen Material des Piezotransformators gibt. Eine Kurve 20 beschreibt den Verlauf des mechanischen Drucks im piezoelektrischen Material des Piezotransformators über der longitudinalen Ortsachse 19. Man erkennt, dass im Eingangsbereich sich eine Halbwelle ausbildet während sich im Ausgangsbereich eine Vollwelle der mechanischen Schwingung ausbildet.

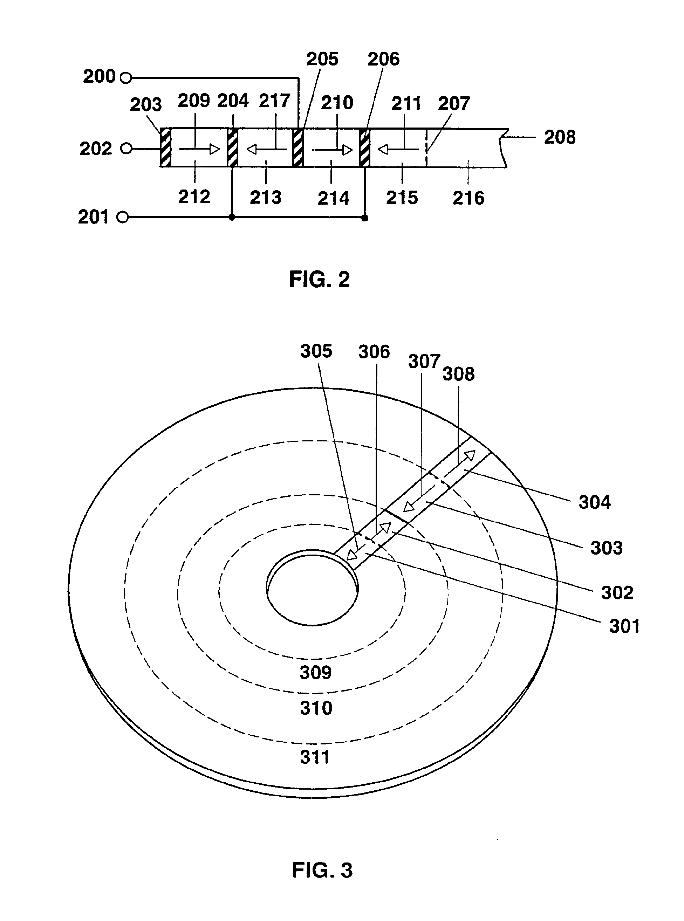

In Figur 2 ist eine alternative Ausführung des Eingangsbereichs des Piezotransformators aus Figur 1 dargestellt. Im Unterschied zu Figur 1 ist in Figur 2 der Eingangsbereich nicht in zwei sondern in vier Sektionen 212, 213, 214 und 215 unterteilt. Aneinander angrenzende Sektionen sind erfindungsgemäß invers zueinander polarisiert. Dies wird durch Pfeile 209, 217, 210 und 211 verdeutlicht. Durch eine gestrichelte Linie 207 wird das Ende des Eingangsbereichs angedeutet. Es schließt sich die erste Sektion des Ausgangsbereichs 216 an. Eine Bruchlinie 208 soll andeuten dass der Ausgangsbereich fortgesetzt wird, beispielsweise in der Form wie er in Figur 1 dargestellt ist. Der alternative Eingangsbereich in Figur 2 besitzt drei wesentliche Elektroden. Eine Erste 204 ist zwischen der ersten Sektion 212 und der zweiten Sektion 213 angeordnet; eine Zweite 205 ist zwischen der zweiten Sektion 213 und der dritten Sektion 214 angeordnet; eine Dritte 206 ist zwischen der dritten Sektion 214 und der vierten Sektion 215 angeordnet. Ebenso wie die oben angesprochenen Elektroden können auch diese Elektroden sowohl an der Oberfläche als auch innerhalb des piezokeramischen Materials angeordnet sein. Die erste und die dritte Elektrode 204 und 206 sind miteinander und mit einem ersten Eingangs-Anschluss 201 verbunden. Die zweite Elektrode 205 ist mit einem zweiten Eingangs-Anschluss 200 verbunden. Eine weitere Elektrode 202, die am Rand des Eingangsbereichs angeordnet ist, ist für die prinzipielle Funktion des Piezotransformators nicht nötig. Sie kann zum Abgriff von Steuer- und Regelsignalen benutzt werden. Die elektrische Spannung die nötig ist, um den Piezotransformator an seinen Eingangs-Anschlüssen 200 und 201 anzuregen, ist bei einem erfindungsgemäßen Eingangsbereich entsprechend Figur 2 nur ein viertel so hoch, wie bei einem Eingangsbereich, der nur aus einer Sektion besteht.

Die Piezotransformatoren in Figur 1 und 2 gehen von einer quaderförmigen Topologie aus. In Figur 3 ist eine ringförmige Ausgestaltung eines erfindungsgemäßen Piezotransformators dargestellt. In einer Schnittdarstellung wird der innere Aufbau verdeutlicht. Der Eingangsbereich ist in zwei Sektionen 301 und 302 unterteilt, die zwei innere Ringe bilden. Die Polarisierung der beiden Sektionen 301 und 302 ist radial und invers zueinander. Pfeile 305 und 306 deuten die Polarisierung an. Eine Linie 309 markiert die Trennung der beiden Sektionen 301 und 302. Eine Linie 310 markiert die Trennung zwischen Ein- und Ausgangsbereich. Der Ausgangsbereich besteht aus zwei Sektionen 303 und 304 die Ringe außerhalb des Eingangsbereichs bilden. Die Polarisierung der beiden Sektionen 303 und 304 des Ausgangsbereichs ist radial und invers zueinander. Pfeile 307 und 308 deuten die Polarisierung an. Eine Linie 311 markiert die Trennung der beiden Sektionen 303 und 304. Aus Gründen der Übersichtlichkeit sind in Figur 3 keine Elektroden eingezeichnet. Sie liegen analog zu den Positionen in Figur 1. Der Piezotransformator in Figur 3 bildet eine ringförmige Variante des Piezotransformators aus Figur 1. Gleichermaßen können auch andere erfindungsgemäße Piezotransformatoren, wie z. B. in Figur 2 dargestellt, in der Ringform aufgebaut werden. Dies gilt auch für die Scheiben-, Zylinder- und Rohrform. Die genannten Ausführungsformen unterscheiden sich in der Bandbreite der Resonanz. Je nach gewünschten Resonanzeigenschaften kann eine Ausführungsform gewählt werden.

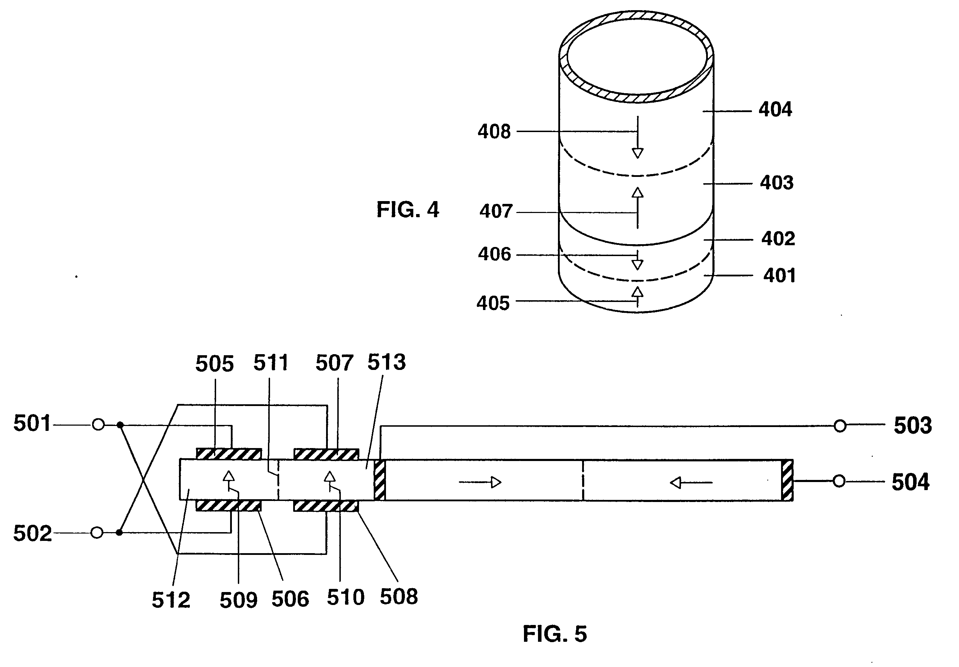

In Figur 4 ist eine rohrförmige Ausführung des in Figur 1 erläuterten Piezotransformators dargestellt. Im unteren Teil des Rohrs liegen zwei Ringe 401 und 402 übereinander, die die Sektionen des Eingangsbereichs bilden. Darüber liegen zwei Ringe 403 und 404, die die Sektionen des Ausgangsbereichs bilden. Die Polarisierung der Sektionen verläuft in Richtung der Mittelachse des Rohres. Wie durch Pfeile 405, 406, 407 und 408 angedeutet ist die Polarisierung erfindungsgemäß invers in aneinander angrenzenden Sektionen.

In Figur 5 ist der Eingangsbereich in einer abgewandelten Form der Realisierung des erfinderischen Gedankens ausgeführt. Der Eingangsbereich ist erfindungsgemäß in eine erste und eine zweite Sektionen 512 und 513 aufgeteilt. Eine Linie 511 deutet die Trennung der beiden Sektionen 512 und 513 an. Beide Sektionen 512 und 513 sind in diesem Beispiel in gleicher Richtung transversal polarisiert. Pfeile 509 und 510 deuten die Polarisierung an. Jede Sektion 512 und 513 besitzt ein Paar von Elektroden 505, 506 und 507, 508, die so angeordnet sind dass sie ein elektrisches Feld in Polarisierungsrichtung erzeugen können. Die Elektroden 505, 506 und 507, 508 sind im Ausführungsbeispiel zur abgewandelten Realisierung des erfinderischen Gedankens nach Figur 5 parallel bezüglich der Eingangsanschlüsse geschaltet. Da, wie oben ausgeführt, beide Sektionen des Eingangsbereichs 512 und 513 in gleicher Richtung polarisiert sind, sind deshalb erfindungsgemäß die Elektroden über Kreuz mit den Eingangs-Anschlüssen verbunden. D.h. die obere Elektrode 505 der ersten Sektion 512 ist mit der unteren Elektrode 508 der zweiten Sektion 513 und einem ersten Eingangs-Anschluss 501 verbunden; während die untere Elektrode 506 der ersten Sektion 512 mit der oberen Elektrode 507 der zweiten Sektion 513 und einem zweiten Eingangsanschluss 502 verbunden ist. Eine gegebene Eingangsspannung erzeugt bei dieser Verschaltung erfindungsgemäß in einer Sektion ein elektrisches Feld, das in Richtung der Polarisierung zeigt und in der anderen Sektion entgegen der Richtung der Polarisierung zeigt. Erfindungsgemäß wird durch diese Anordnung die elektrische Spannung, die an den Eingangs-Anschlüssen 501 und 502 nötig ist, um einen gewünschten mechanischen Druck zu erzielen, gegenüber einem Eingangsbereich mit nur einer Sektion halbiert und damit das Übersetzungsverhältnis verdoppelt. Der Ausgangsbereich, der mit Ausgangs-Anschlüssen 503 und 504 verbunden ist, ist identisch mit dem Ausgangsbereich in Figur 1. Vorteilhaft gegenüber dem Piezotransformator in Figur 1 ist die mögliche Potenzialtrennung zwischen Einund Ausgangsanschlüssen.

## Patentansprüche

1. Piezotransformator, der in einen Eingangbereich und einen Ausgangsbereich aufgeteilt ist
**dadurch gekennzeichnet, dass** zumindest einer dieser beiden Bereiche in mindestens 2 Sektionen (13-16, 212-215, 301-304, 401-404, 512-513) unterteilt ist, wobei aneinander angrenzende Sektionen in mindestens einem Bereich invers zueinander polarisiert sind und zumindest einer dieser beiden Bereiche in longitudinaler Richtung polarisiert ist.

2. Piezotransformator gemäß Anspruch 1 wobei der Eingangsbereich in mindestens zwei Sektionen (13,14, 212-215, 301, 302, 401,402, 512, 513) unterteilt ist, **dadurch gekennzeichnet, dass** ein erster Eingangs-Anschluss (2, 200) mit einer Elektrode (6, 205) verbunden ist, die so angeordnet ist, dass sie an der Verbindungsstelle von zwei Sektionen (13, 14, 213, 214) wirkt, während ein zweiter Eingangsanschluss (2, 201) mit Elektroden (5, 7, 204, 206) verbunden ist, die so angeordnet sind, dass sie an der der Verbindungsstelle abgewandten Seite der o. g. Sektionen (13, 14, 213, 214) wirken.

3. Piezotransformator gemäß Anspruch 2, **dadurch gekennzeichnet, dass** die Sektionen (13,14, 212-215, 301, 302, 401,402, 512, 513) des Eingangsbereichs gleiche Abmessungen in longitudinaler Richtung aufweisen.

4. Piezotransformator mit zwei Ausgangs-Anschlüssen gemäß Anspruch 1 wobei der Ausgangsbereich in mindestens zwei Sektionen (15, 16, 303, 304, 403, 404) unterteilt ist, **dadurch gekennzeichnet, dass** jeder Ausgangs-Anschluss (3, 4, 503, 504) mit je einer Elektrode (7, 8) verbunden ist, die so angeordnet ist, dass sie in longitudinaler Richtung nur an einer Außenseite einer außen liegenden Sektion (15, 16, 303, 304, 403, 404) wirkt.

5. Piezotransformator gemäß Anspruch 4, **dadurch gekennzeichnet, dass** die Sektionen (15, 16, 303, 304, 403, 404) des Ausgangsbereichs gleiche Abmessungen in longitudinaler Richtung aufweisen.

6. Piezotransformator gemäß den Ansprüchen 3 und 5, **dadurch gekennzeichnet, dass** das Verhältnis für die Abmessungen der Sektionen des Ausgangsbereichs(15, 16, 303, 304, 403, 404) bezogen auf die Abmessungen der Sektionen (13,14, 212-215, 301, 302, 401,402, 512, 513) des Eingangsbereichs jeweils in longitudinaler Richtung ganzzahlig ist.

7. Piezotransformator gemäß einem der Ansprüche 1-6 **dadurch gekennzeichnet, dass** die Eingangs-Anschlüsse (1, 2, 200, 201, 501, 502) mit den Ausgangs-Anschlüssen (3, 4, 503, 504) vertauscht sind.

8. Piezotransformator gemäß einem der Ansprüche 1-7 **dadurch gekennzeichnet, dass** der Piezotransformator die Form eines Quaders aufweist.

9. Piezotransformator gemäß einem der Ansprüche 1-7 **dadurch gekennzeichnet, dass** der Piezotransformator die Form einer Scheibe aufweist.

10. Piezotransformator gemäß einem der Ansprüche 1-7 **dadurch gekennzeichnet, dass** der Piezotransformator die Form eines Ringes aufweist.

11. Piezotransformator gemäß einem der Ansprüche 1-7 **dadurch gekennzeichnet, dass** der Piezotransformator die Form eines Zylinders aufweist.

12. Piezotransformator gemäß einem der Ansprüche 1-7 **dadurch gekennzeichnet, dass** der Piezotransformator die Form eines Rohres aufweist.

13. Piezotransformator, der in einen Eingangbereich und einen Ausgangsbereich aufgeteilt ist
**dadurch gekennzeichnet, dass** zumindest einer dieser beiden Bereiche in eine erste und eine zweite Sektion (512, 513) unterteilt ist, die transversal polarisiert sind, wobei jede Sektion ein Paar von Elektroden (505, 506, 507, 508) besitzt, die so miteinander und mit einem Paar von Anschlüssen (501, 502) verbunden sind, dass eine gegebene Spannung an besagten Anschlüssen (501, 502) in der ersten Sektion ein elektrisches Feld erzeugt, das in Richtung der Polarisierung der ersten Sektion verläuft, während sie in der zweiten Sektion ein elektrisches Feld erzeugt, das entgegengesetzt der Richtung der Polarisierung der zweiten Sektion verläuft.
